Europäisches Patentamt

European Patent Office

Office européen des brevets

(11) Publication number: **0 092 645**
**B1**

(12) **EUROPEAN PATENT SPECIFICATION**

(45) Date of publication of patent specification: **11.01.89**

(21) Application number: **83100929.5**

(22) Date of filing: **01.02.83**

(51) Int. Cl.⁴: **H 01 L 29/10, H 01 L 29/72**

(54) Transistor and circuit including a transistor.

(30) Priority: **26.04.82 US 371849**

(43) Date of publication of application:
**02.11.83 Bulletin 83/44**

(45) Publication of the grant of the patent:
**11.01.89 Bulletin 89/02**

(84) Designated Contracting States:
**DE FR GB**

(56) References cited:
**EP-A-0 036 501**
**GB-A-2 128 026**
**US-A-3 209 215**
**IBM TECHNICAL DISCLOSURE BULLETIN, vol. 24, no. 7A, December 1981, pages 3229-3231, New York, US; W.P. DUMKE et al.: "Heterostructure long lifetime hot electron transistor"**
**SOLID-STATE ELECTRONICS, vol. 23, no. 6, June 1980, pages 599-603, Pergamon Press Ltd., Oxford, GB; A. CHANDRA et al.: "A study of the conduction properties of a rectifying nGaAs-n(Ga,Al)As heterojunction"**

(73) Proprietor: **International Business Machines Corporation**
**Old Orchard Road**
**Armonk, N.Y. 10504 (US)**

(72) Inventor: **Solomon, Paul Michael**
**2220 Brookside Avenue**
**Yorktown Heights New York, 10598 (US)**

(74) Representative: **Hobbs, Francis John**
**IBM United Kingdom Limited Intellectual Property Department Hursley Park**
**Winchester Hampshire SO21 2JN (GB)**

(56) References cited:
**IBM TECHNICAL DISCLOSURE BULLETIN, vol. 21 no. 4, September 1978, pages 1689-1690, New York, US; C-A. CHANG et al.: "Semiconductor heterostructure devices"**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

## Description

This invention relates to a transistor and a circuit including a transistor.

Efforts have been made to reduce the dimensions of transistors and to increase the carrier velocity so as to reduce the transit time of the carriers and thereby improve the speed of response. With such efforts, however, have come difficulty in manufacture and serious restrictions on the impressed voltages.

Published European patent application No. 33496 discloses a transistor having a two-stage emitter in which there is a high density of carriers in the first stage and a low barrier in the second stage adjacent to a high conductivity base. The high conductivity base has a width of the order of the mean free path of an electron.

The invention seeks to provide an improved high speed transistor.

A transistor comprises, according to the invention, first and second epitaxial semiconductor regions of the same conductivity type, the conductivity of the second region being lower than that of the first region and the second region having a lower energy bandgap than the first region, an emitter electrode connected to the side of the second region remote from the interface where the epitaxial smaller bandgap region joins the larger bandgap region, a base electrode making contact with a part of the second region adjacent the interface, and a collector electrode connected to the side of the first region remote from the interface.

In a transistor according to the invention, a field induced layer between two semiconductor regions of the same conductivity type, but of different conductivity level, serves as a base region. The layer is produced by the field of an electrical bias applied to the transistor.

The layer is of the order of the means free path of an electron so that ballistic type performance is achieved in which the carriers go from the emitter region to the collector region of the transistor by drift rather than by diffusion.

How the invention can be carried out will now be described by way of example, with reference to the accompanying drawings, in which:-

Fig. 1 is a schematic illustration of a transistor embodying the invention;

Figs. 2.1, 2.2 and 2.3 are dimensionally correlated band energy diagrams of the regions of the device of Fig. 1 under the influence of bias;

Fig. 3 is a graph of the electrical operating characteristics of the transistor of the invention.

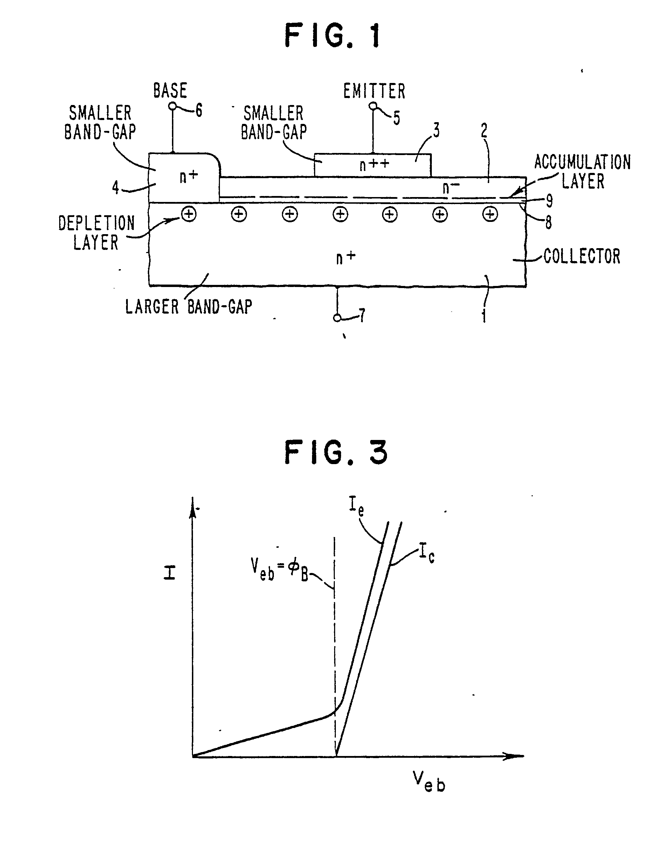

The structure of the transistor is shown in Fig. 1. On a high conductivity larger bandgap region 1, there is an epitaxial smaller bandgap region 2 having a lower conductivity. The region 2 is fairly thin and in turn has epitaxial therewith a region 3 of higher conductivity also with a smaller bandgap than the region 1. A higher conductivity portion 4 of the region 2 serves as an electrode to what will be the base under the influence of bias. There are emitter, base and collector external electrical connections 5, 6 and 7, respectively. For purposes of facilitating explanation, n conductivity type will be used in the description with higher and lower conductivity being shown as + and − respectively, although in the light of the principles set forth, it will be readily apparent to one skilled in the art that p conductivity type can be employed with appropriate adjustments.

Under the influence of bias, at the interface 8 where the epitaxial smaller bandgap region 2 joins the larger bandgap region 1, there will be a depletion layer in the region 1 that is shown as a series of plus circles. There will also be a corresponding accumulation layer 9 on the other side of the interface 8 in the small bandgap region 2. The larger bandgap region 1 serves as the collector of the transistor. The accumulation layer 9 in the smaller bandgap region serves as the base region to which the external circuit contact 4 is connected. the emitter is made up of the upper part of the region 2 and a region 3 which is of still higher conductivity shown as $n^{++}$, thereby providing a large sink of electrons which electrons encounter a small barrier at the low conductivity region 2 to the accumulation region 9. The accumulation region 9 serves as the base with a thickness dependent on the material specification and the bias and is of the order of the mean free path of an electron. Thus, the transistor has a high speed ballistic conductivity type base produced by a field from the operating potentials.

Continuing to refer to Fig. 1, the material of region 1 which has the larger bandgap and serves as the collector may be, for example, GaAlAs. The conductivity of the collector region 1 is moderately high, $n^+$, such as occurs with arsenic doping of the order of $10^{17}$ atoms per cc.

At the interface 8, the eipitaxial region 2 of a smaller bandgap semiconductor material joins the region 1. The region 2 may be GaAs and has a lower n conductivity such as by arsenic doping of the order of $10^{15}$ atoms per cc.

The thickness of the region 2 is of the order of 1,000 Angstroms. A higher conductivity region 3 shown as $n^{++}$ serves as part of the emitter. The region 3 has a smaller bandgap than region 1 and the material GaAs is satisfactory. The region 3 is to provide a large source of carriers for the emitter of the device. The $n^{++}$ can be provided by doping of the order of $10^{18}$ atoms per cc with arsenic. The ohmic contact 4 to the accumulation layer 9 which will serve as a base may be locally doped with arsenic to the order of $10^{17}$ atoms per cc.

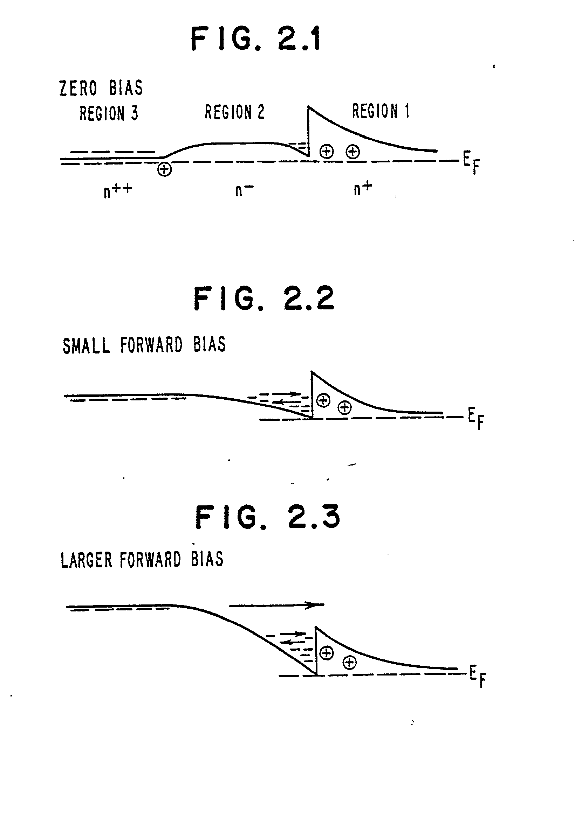

The effect on the structure of Fig. 1 of bias, as shown in the correlated Figs. 2.1, 2.2 and 2.3, is that there is a spillover of electrons from the wide bandgap collector 1 and from the heavily doped emitter 3 which converts the initial high resistivity of the region 2 in the vicinity of the interface 8 and produces an accumulation layer 9 at the interface 8 which is ohmically connected through the region 4 to the external base contact 6.

Referring to Fig. 2.1 for zero bias, in the $n^{++}$ region 3 corresponding to the carrier sink part of the emitter, a large number of carriers are shown. On the other side of then n⁻ region 2, at the interface with the n⁺ region 1, the depletion region is shown in the n⁺ region adjacent the barrier as the plus signs and the presence of negative carriers in the accumulation region 9 is shown as a number of minus signs in the potential well at the location of the interface.

Referring next to Fig. 2.2, under the influence of a small forward bias additional electrons are injected from the large supply in the n⁺⁺ region 3 part of the emitter. However, the current flow at low bias is small since these electrons cannot escape over the heterojunction barrier that appears at the interface 8 due to the difference in bandgap between regions 1 and 2 and diffuse laterally to the base contact 4.

Referring next to Fig. 2.3, under larger forward bias at emitter base voltages exceeding the heterojunction barrier height, electrons will cross the base region and be collected by the collector since the energy at injection is now higher than the collector barrier. The movement of the electrons across the base region is substantially collision free since the thickness of the field induced base region is less than the means free path of an electron. Hence, no significant additional electrons will be lost in the base.

The electrical operating characteristics of the device are shown in Fig. 3. Once the collector barrier $\phi_B$, shown dashed in Fig. 3, has been surmounted, both the emitter and collector current $I_e$ and $I_c$ will increase rapidly giving the device power gain.

In fabricating a transistor embodying the invention, it is convenient to employ the well known technique of molecular beam epitaxy (MBE), since small dimensions are achievable with this technique and the temperatures employed are not so high as to move the impurity significantly. The MBE technique has been available for a number of years and it enables semiconductors to be grown in a epitaxial manner with thicknesses as small as around 2 nm (20 Angstroms) and to produce sharp boundaries of the order of 0.5 nm (5 Angstroms)..With molecular beam epitaxy, the epitaxial heterojunction interface can be achieved around 0.5 nm (5 Angstroms) from a doping of around $10^{17}$ in the region 1 to around $10^{15}$ in region 2 and the thickness of the region 2 can be confined to something less than 100 nm (1,000 Angstroms) to the interface of the region 3 at which a doping level change to around $10^{19}$ can take place.

Contacts to the various electrodes can be formed by standard photolithographic processes.

There has been described a high speed transistor in which the accumulation region in a heterojunction formed between two different bandgap semiconductors is used as the base for ballistic majority carrier transfer. The transistor can provide amplification with wide bandwidth and switching in the order of $10^{-12}$ seconds.

## Claims

1. A transistor comprising first and second epitaxial semi-conductor regions (1, 2) of the same conductivity type, the conductivity of the second region (2) being lower than that of the first region (1) and the second region having a lower energy bandgap than the first region, an emitter electrode (5) connected to the side of the second region remote from the interface (8) where the epitaxial smaller bandgap region (2) joins the larger bandgap region (1), a base electrode (6) making contact with a part of the second region adjacent the interface (8), and a collector electrode (7) connected to the side of the first region remote from the interface (8).

2. A transistor as claimed in claim 1, in which the emitter electrode comprises a third semiconductor regions epitaxial with the second region, the third region having a higher conductivity than that of both said first and second regions and having the same bandgap as that of the second semi-conductor regions.

3. A transistor as claimed in claim 2, in which the first semi-conductor region is of GaAlAs and the second and third semi-conductor regions are of GaAs.

4. A transistor as claimed in any preceding claim, in which the base electrode comprises a fourth semi-conductor region (4) of the higher conductivity than that of the second region and forming an ohmic electrical contact therewith.

5. A transistor as claimed in any preceding claims, made of n-type conductivity materials.

6. A circuit including a transistor structure as claimed in any preceding claim, and means to apply such a bias voltage across the emitter and base electrodes that electrical conduction occurs across the interface.

## Patentansprüche

1. Transistor mit einem ersten und einem zweiten Epitaxiehalbleiterbereich (1, 2) desselben Leitfähigkeitstyps, wobei die Leitfähigkeit des zweiten Bereichs (2) kleiner als die des ersten Bereichs (1) ist und der zweite Bereich eine kleinere Bandabstandsenergie als der erste Bereich aufweist, mit einer Emitterelektrode (5), die an die Seite des zweiten von der Grenzfläche (8) räumlich entfernten Bereichs angeschlossen ist, wo der epitaxial kleinere Bandabstandsbereich (2) auf den größeren Bandabstandsbereich (1) zusammmentrifft, mit einer Basiselektrode (6), die einen Kontakt mit einem Teil des an die Grenzfläche (8) angrenzenden zweiten Bereichs herstellt, und mit einer Kollektorelektrode (7), die mit der Seite des ersten von der Grenzfläche (8) räumlich entfernten Bereichs verbunden ist.

2. Transistor nach Anspruch 1, bei dem die Emitterelektrode einen dritten, mit dem zweiten Bereich epitaxialen Halbleiterbereich aufweist, wobei der dritte Bereich eine höhere Leitfähigkeit als sowohl der erste und der zweite Bereich sowie denselben Bandabstand wie der zweite Halbleiter-

bereich aufweist.

3. Transistor nach Anspruch 2, bei dem der erste Halbleiterbereich aus GaAlAs und der zweite sowie der dritter Halbleiterbereich aus GaAs besteht.

4. Transistor nach einem der vorhergehenden Ansprüche, bei dem die Basiselektrode einen vierten Halbleiterbereich (4) mit einer höheren Leitfähigkeit als der des zweiten Bereichs aufweist und dabei einen ohmschen electrischen Kontakt bildet.

5. Transistor nach einem der vorhergehenden Ansprüche, der aus n-Typ-Leitfähigkeitsmaterial besteht.

6. Schaltkreis mit einer Transistorstruktur nach einem der vorhergehenden Ansprüche und Mitteln zum Anlegen einer solchen Vorspannung an die Emitter- und Basiselektroden, daß eine elektrische Leitung durch die Grenzfläche hindurch auftritt.

**Revendications**

1. Transistor comprenant une première et une deuxième régions semi-conductrices épitaxiales (1, 2) du même type de conductivité, la conductivité de la deuxième région (2) étant inférieure à celle de la première région (1) et la deuxième région ayant un intervalle de bande d'énergie inférieur à celui de la première région, une électrode d'émetteur (5) connectée au côté de la deuxième région opposé à l'interface (8) où la région épitaxiale de plus petit intervalle de bande (2) se raccorde à la région de plus grand intervalle de bande (1), une électrode de base (6) formant contact avec une partie de la deuxième région adjacente à l'interface (8), et une électrode de collecteur (7) connectée au côté de la première région opposé à l'interface (8).

2. Transistor suivant la revendication 1, dans lequel l'électrode d'émetteur comprend une troisième région semi-conductrice épitaxiale avec la deuxième région, la troisième région ayant une conductivité supérieure à celle desdites première et deuxième régions et ayant le même intervalle de bande que la deuxième région semi-conductrice.

3. Transistor suivant le revendication 2, dans lequel la première région semi-conductrice est en GaAlAs et les deuxième et troisième régions semi-conductrices sont en GaAs.

4. Transistor suivant l'une quelconque des revendications précédentes, dans lequel l'électrode de base comprend une quatrième région semi-conductrice (4) de conductivité supérieure à celle de la deuxième région et formant un contact électrique ohmique avec celle-ci.

5. Transistor suivant l'une quelconque des revendications précédentes, fabriqué en matière de conductivité de type n.

6. Circuit comprenant une structure de transistor suivant l'une quelconque des revendications précédentes, et moyens pour appliquer une tension de polarisation entre les électrodes d'émetteur et de base telle qu'une conduction électrique se produit à travers l'interface.

# FIG. 1

# FIG. 3

# F I G.  2.1

ZERO BIAS

# F I G.  2.2

SMALL FORWARD BIAS

# F I G.  2.3

LARGER FORWARD BIAS